(19) Europäisches Patentamt / European Patent Office / Office européen des brevets

(11) **EP 3 363 093 B1**

(12) **FASCICULE DE BREVET EUROPEEN**

(45) Date de publication et mention
de la délivrance du brevet:
**04.12.2019 Bulletin 2019/49**

(51) Int Cl.:
*H02J 3/36* (2006.01)          *H02H 7/26* (2006.01)
*H02H 7/28* (2006.01)

(21) Numéro de dépôt: **16794379.4**

(22) Date de dépôt: **14.10.2016**

(86) Numéro de dépôt international:
**PCT/FR2016/052656**

(87) Numéro de publication internationale:
**WO 2017/064434 (20.04.2017 Gazette 2017/16)**

(54) **ÉQUIPEMENT D'INTERCONNEXION POUR RÉSEAU HAUTE TENSION CONTINUE**

VERBINDUNGSAUSRÜSTUNG FÜR EIN HOCHSPANNUNGS-GLEICHSTROM-NETZ

INTERCONNECTION EQUIPMENT FOR A HIGH-VOLTAGE DC GRID

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **16.10.2015 FR 1559921**

(43) Date de publication de la demande:
**22.08.2018 Bulletin 2018/34**

(73) Titulaires:
 • **Supergrid Institute
   69100 Villeurbanne (FR)**
 • **Institut Polytechnique de Grenoble
   38500 Grenoble (FR)**
 • **Université Grenoble Alpes
   38400 Saint-Martin-d'Hères (FR)**

(72) Inventeurs:
 • **LEON GARCIA, William
   69372 Cedex 08 Lyon (FR)**
 • **BERTINATO, Alberto
   69372 Cedex 08 Lyon (FR)**
 • **TIXADOR, Pascal
   69372 Cedex 08 Lyon (FR)**
 • **RAISON, Bertrand
   69372 Cedex 08 Lyon (FR)**
 • **LUSCAN, Bruno
   69372 Cedex 08 Lyon (FR)**

(74) Mandataire: **Guérin, Jean-Philippe et al
   Opilex
   32 rue Victor Lagrange
   69007 Lyon (FR)**

(56) Documents cités:
   **EP-A2- 2 908 398     WO-A1-2012/123015**

 • **DESCLOUX JUSTINE ET AL: "Protection system
   for meshed HVDC network using
   superconducting fault current limiters", 2013
   IEEE GRENOBLE CONFERENCE, IEEE, 16 juin
   2013 (2013-06-16), pages 1-5, XP032520073, DOI:
   10.1109/PTC.2013.6652389**

**Description**

L'invention concerne les réseaux de transmission et/ou de distribution de courant continu sous tension élevée, généralement désignés sous l'acronyme HVDC. L'invention porte en particulier sur la sélectivité et le temps de coupure au niveau du nœud confronté à un court-circuit.

Les réseaux HVDC sont notamment envisagés comme une solution à l'interconnexion de sites de production d'électricité disparates ou non synchrones, apparaissant avec le développement des énergies renouvelables. Les réseaux HVDC sont notamment envisagés pour la transmission et la distribution d'énergie produite par des fermes éoliennes offshore plutôt que des technologies de courant alternatif, du fait de pertes en ligne inférieures et d'absence d'incidence des capacités parasites du réseau sur de longues distances. De tels réseaux ont typiquement des niveaux de tension de l'ordre de 50 kV et plus.

Pour de la transmission d'électricité point à point, un sectionnement peut être réalisé par l'intermédiaire d'un convertisseur en bout de ligne, muni d'un disjoncteur. Par contre, le sectionnement ne peut plus être réalisé par un tel convertisseur dans de la transmission multipoints ou multinoeuds. La coupure du courant continu dans de tels réseaux est un enjeu crucial conditionnant directement la faisabilité et le développement de tels réseaux. En effet, l'apparition d'un court-circuit au niveau d'un nœud se propage très rapidement dans tout le réseau. En l'absence de coupure assez rapide au niveau du nœud, le courant de court-circuit continue à croître et peut atteindre plusieurs dizaines de kA en quelques ms. Le courant de court-circuit peut alors dépasser le pouvoir de coupure des disjoncteurs courant continu des différents nœuds. Le courant de court-circuit pourrait aussi endommager l'électronique de puissance utilisée dans les convertisseurs AC/DC.

Une solution connue consiste à positionner un disjoncteur courant continu très rapide en série avec des réactances, pour limiter la vitesse de croissance du courant de court-circuit et permettre sa coupure en un temps très bref. Une mesure locale de tension et de courant au niveau du disjoncteur permet de commander son ouverture en cas d'apparition d'un court-circuit.

Une telle solution induit des pertes non négligeables et repose sur le niveau de rapidité du disjoncteur, ce qui implique un coût de disjoncteur particulièrement élevé. En outre, une telle solution s'avère imparfaite pour obtenir une sélectivité satisfaisante de la coupure en cas de court-circuit et n'a pas encore été éprouvée pour assurer une protection pour de la transmission multinoeuds.

Le document publié par Justine Descloux et alias, le 16 Juin 2013 dans le cadre de la conférence de l'IEEE à Grenoble en 2013, intitulé 'Protection system for meshed HVDC network using superconducting fault current limiters', en pages 1 à 5, décrit un équipement d'interconnexion pour réseau haute tension courant continu. Cet équipement dispose de première et deuxième bornes pour connexion à des lignes d'un réseau haute tension, d'une troisième borne pour connexion à une station locale, et d'un nœud connecté à ces bornes. Un disjoncteur est connecté entre la première borne et le nœud, un autre disjoncteur est connecté entre la deuxième borne et le nœud. Un limiteur de courant à supraconducteur est connecté entre la troisième borne et le nœud. Un tel système ne permet ni de localiser, ni d'isoler rapidement une défaillance.

Le document EP2908398 décrit une structure d'interrupteur série pour réseau haute tension. Cet interrupteur comprend un interrupteur commandé en série avec un limiteur de courant à supraconducteur.

Le document WO2012/123015 décrit des limiteurs de courant positionnés à l'intersection entre des sous segments d'un réseau haute tension courant continu, afin d'éviter la propagation d'une défaillance à tout le réseau.

L'invention vise à résoudre un ou plusieurs de ces inconvénients. L'invention porte ainsi sur un équipement d'interconnexion pour réseau haute tension courant continu, tel que défini dans la revendication 1.

L'invention porte également sur l'objet des revendications dépendantes. Les différentes caractéristiques des revendications dépendantes peuvent également être combinées indépendamment aux caractéristiques de la revendication 1, sans constituer une généralisation intermédiaire.

L'invention porte également sur un réseau électrique haute tension courant continu, comprenant :

- des lignes hautes tension ;
- au moins trois équipements d'interconnexion tels que revendiqués, les première et deuxième bornes de chacun desdits équipements d'interconnexion étant interconnectées par l'intermédiaire desdites lignes hautes tensions.

D'autres caractéristiques et avantages de l'invention ressortiront clairement de la description qui en est faite ci-après, à titre indicatif et nullement limitatif, en référence aux dessins annexés, dans lesquels :

- la figure 1 illustre un exemple simplifié de réseau haute tension courant continu mettant en œuvre des équipements d'interconnexion selon l'invention, associé à des réseaux alternatifs ;
- la figure 2 illustre schématiquement un exemple de mode de réalisation d'un équipement d'interconnexion selon l'invention ;

- la figure 3 illustre un diagramme du mode de fonctionnement d'un limiteur de courant à supraconducteur, en fonction de sa température et de sa densité de courant ;
- la figure 4 illustre un diagramme du mode de fonctionnement d'un limiteur de courant à supraconducteur en fonction de son courant et du temps de maintien de ce courant;
- la figure 5 illustre schématiquement un exemple de dispositif de commande d'un équipement d'interconnexion selon l'invention ;
- la figure 6 illustre un cas de figure de court-circuit appliqué à un équipement d'interconnexion selon la figure 2 ;
- la figure 7 est un diagramme illustrant différents courants lors du court-circuit appliqué à l'équipement d'interconnexion de la figure 2 ;
- la figure 8 est un diagramme illustrant la température de différents limiteurs de courant lors du court-circuit appliqué à l'équipement d'interconnexion de la figure 2 ;
- la figure 9 illustre schématiquement un dispositif de protection d'une station locale ;
- la figure 10 illustre le rapport tension sur tension nominale de ligne lors d'un court-circuit au niveau d'un dispositif de protection selon un autre aspect de l'invention.

L'invention propose un équipement d'interconnexion comportant au moins trois bornes connectées à un nœud, la connexion entre chacune de ses bornes et le nœud inclut un limiteur de courant à supraconducteur et un interrupteur commandé (ou disjoncteur) connectés en série. Un dispositif configuré pour injecter un courant électrique dans le nœud lors d'une baisse de tension sur ce nœud (en particulier un condensateur connecté entre le nœud et la terre stocke de l'énergie dans l'exemple détaillé par la suite) est destiné à déclencher un des limiteurs de courant sur la borne duquel intervient un court-circuit. L'énergie injectée par ce dispositif traverse ce limiteur de courant vers le court-circuit, puis l'interrupteur commandé connecté en série est ouvert. Ainsi, seul ce limiteur de courant est déclenché et pas les autres limiteurs de courant, une sélectivité de l'ouverture des interrupteurs commandés étant ainsi obtenue.

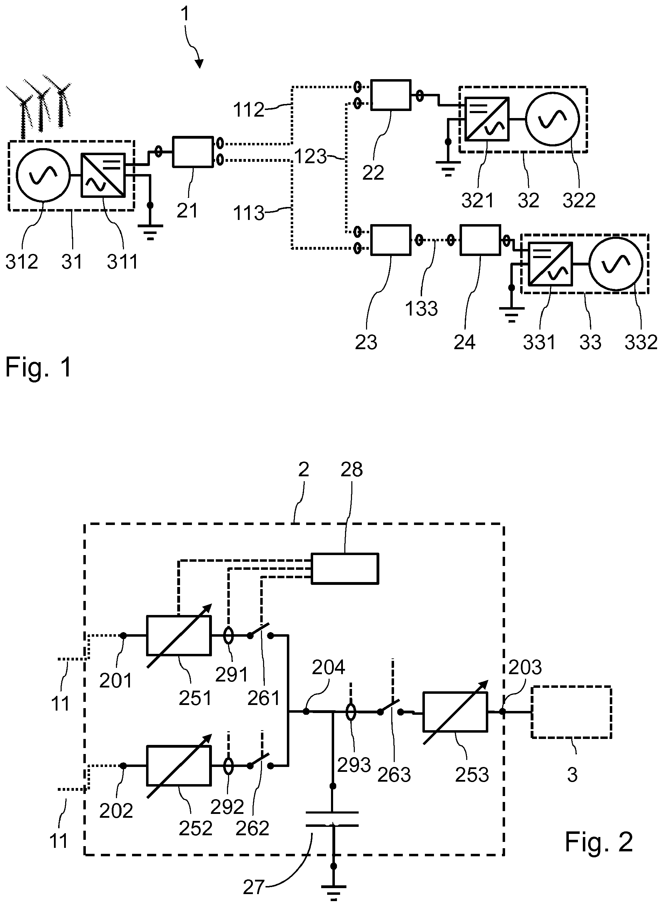

La figure 1 est une représentation schématique simplifiée d'un exemple de réseau haute tension courant continu 1 mettant en œuvre des équipements d'interconnexion 21, 22 et 23 selon l'invention, le réseau haute tension courant continu 1 étant associé à des réseaux alternatifs.

Le réseau 1 comprend des lignes haute tension 112, 113,123 et 133. La ligne haute tension 112 raccorde les équipements 21 et 22, la ligne haute tension 123 raccorde les équipements 22 et 23, et la ligne haute tension 113 raccorde les équipements 21 et 23. Le réseau 1 comprend des stations locales 31, 32 et 33.

Les stations locales 31, 32 et 33 peuvent inclure de façon connue en soi des générateurs électriques (tels que des champs d'éoliennes, des usines marémotrices, des centrales électronucléaires, des centrales électriques thermiques ou encore des générateurs photovoltaïques) ou des réseaux locaux de transport ou de consommation.

Les stations locales 31, 32 et 33 comportent ici chacune un convertisseur continu/alternatif et un équipement (génératrice ou charge) alternatif représentant l'ensemble du réseau alternatif local dans un souci de simplification. La station locale 31 comporte ainsi un convertisseur 311 connecté à l'équipement 21 et une machine tournante 312 utilisée en génératrice connectée au convertisseur 311. La station locale 32 comporte un convertisseur 321 connecté à l'équipement 22 et un équipement alternatif 322 connecté au convertisseur 321. La station locale 33 comporte un convertisseur 331 connecté à l'équipement 23 et un équipement alternatif 332 connecté au convertisseur 331. La station locale 33 est ici connectée à l'équipement 23 par l'intermédiaire d'un dispositif de protection 24 et d'une ligne haute tension 133. Les convertisseurs 311, 321 et 331 sont avantageusement de type convertisseur source de tension VSC, par exemple de type modulaire multi niveau ou MMC (pour Modular Multi-Level Converter) de type demi-pont, pont complet, ou convertisseur source de tension à deux niveaux. Dans un souci de simplification, on a illustré ici uniquement une polarité du réseau haute tension. Chaque équipement de connexion 31 à 33 peut bien entendu présenter des bornes et composants dupliqués pour gérer l'autre polarité du réseau.

La figure 2 illustre schématiquement un exemple d'un mode de réalisation d'un équipement d'interconnexion 2. L'équipement d'interconnexion 2 comporte une borne 201 et une borne 202 destinées à être connectées à des lignes haute tension courant continu respectives 11, elles-mêmes connectées à d'autres équipements d'interconnexion. Une troisième borne 203 est destinée à être connectée à une station locale 3 (mais peut être connectée à une autre ligne haute tension.

Un nœud 204 est connecté aux bornes 201,202 et 203 par l'intermédiaire de branches respectives. Le nœud 204 est ainsi connecté :

- à la borne 201 par l'intermédiaire d'un limiteur de courant à supraconducteur 251 et d'un interrupteur commandé 261 connectés en série ;
- à la borne 202 par l'intermédiaire d'un limiteur de courant à supraconducteur 252 et d'un interrupteur commandé 262 connectés en série ;
- à la borne 203 par l'intermédiaire d'un limiteur de courant à supraconducteur 253 et d'un interrupteur commandé 263 connectés en série.

Les ordres de connexion du limiteur de courant à supraconducteur 251 et de l'interrupteur commandé 261 entre la borne 201 et le nœud 204, du limiteur de courant à supraconducteur 252 et de l'interrupteur commandé 262 entre la borne 202 et le nœud 204, ou du limiteur de courant à supraconducteur 253 et de l'interrupteur commandé 263 entre la borne 203 et le nœud 204, peuvent être intervertis par rapport à la configuration illustrée. Les limiteurs de courant 251 à 253 sont configurés pour maintenir le courant traversant les interrupteurs commandés 261 à 263 à un niveau inférieur au pouvoir de coupure de ces interrupteurs commandés, pour ainsi permettre l'ouverture effective d'un de ces interrupteurs 261 à 263 en cas de court-circuit. Avec des limiteurs de courant 251 à 253 du type à supraconducteur, ceux-ci ont une différence de potentiel nulle entre leurs bornes quand ils sont en état supraconducteur, ce qui permet donc de limiter les pertes induites dans chaque branche. Les limiteurs de courant 251 à 253 peuvent soit être constitués d'un composant limiteur de courant, soit inclure une combinaison de composants connectés de façon connue en soi en parallèle ou en série avec un composant limiteur de courant, pour obtenir une fonction de limitation de courant.

Les interrupteurs commandés 261 à 263 sont avantageusement des interrupteurs électromécaniques, notamment du fait des faibles pertes en ligne qu'ils sont capables de générer.

Un condensateur 27 est connecté entre la terre et le nœud 204. En fonctionnement normal, la tension aux bornes du condensateur 27 est égale à la tension nominale sur les lignes haute tension 11.

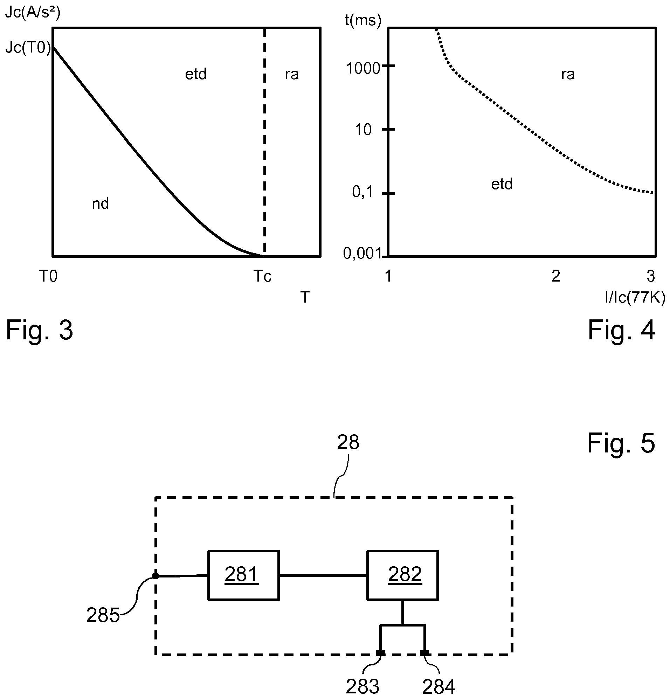

L'équipement d'interconnexion 2 comprend en outre ici un circuit de commande 28 configuré pour commander sélectivement l'ouverture de chacun des interrupteurs commandés 261 à 263. Un exemple de circuit de commande 28 est par exemple illustré schématiquement à la figure 5. Le circuit de commande 28 comporte par exemple un circuit de traitement 282. Le circuit de traitement 282 est connecté à une interface d'entrée 283 destinée à recevoir une mesure du courant traversant un limiteur de courant, et à une interface 284 destinée à recevoir une mesure de tension aux bornes de ce limiteur de courant. Des interfaces dédiées pourront bien entendu être prévues pour mesurer ces paramètres pour chacun des limiteurs de courant. Le circuit de traitement 282 est connecté à un relais 281. Le relais 281 est lui-même connecté à une interface de sortie 285. Par une commande appropriée, le circuit de traitement 282 peut appliquer une commande d'ouverture sur le relais 281, relais 281 appliquant alors une commande d'ouverture sur l'interface de sortie 285. L'interface de sortie 285 est connectée à une électrode de commande d'un des interrupteurs commandés. Chacun des interrupteurs commandés 261 à 263 peut présenter une interface de sortie et un relais dédiés. Chacun des interrupteurs commandés 261 à 263 pourra présenter un temps de coupure compris entre 10 et 50ms (par exemple de 25ms), après réception de sa commande d'ouverture.

Le circuit de commande 28 mesure ici le courant traversant chaque borne 201 à 203, par exemple en mesurant le courant traversant chacun des limiteurs de courant 251 à 253. Lorsqu'un courant mesuré dépasse un seuil, par exemple le courant critique d'un des limiteurs de courant 251 à 253, le circuit de commande 28 détermine qu'un court-circuit est probablement présent au niveau d'une des bornes 201 à 203. Le circuit de commande 28 mesure ici également la tension aux bornes de chaque limiteur de courant 251 à 253. Lorsqu'une tension mesurée pour un limiteur de courant dépasse un seuil, le circuit de commande 28 détermine que ce limiteur de courant est déclenché, puisqu'un limiteur de courant à supraconducteur présente une tension sensiblement nulle en fonctionnement normal. Lorsque le circuit de commande 28 détermine que le seuil de courant et le seuil de tension sont dépassés pour un limiteur de courant, le circuit de commande 28 commande l'ouverture de l'interrupteur commandé avec lequel ce limiteur de courant est connecté en série. Avantageusement, le circuit de commande 28 calcule le carré de la tension mesurée aux bornes de chacun des limiteurs 251 à 253. Lorsque le carré de la tension aux bornes d'un des limiteurs dépasse un seuil, le circuit de commande 28 peut également commander l'ouverture de l'interrupteur commandé connecté en série avec ce limiteur. Le carré de la tension aux bornes d'un limiteur de courant à supraconducteur est en effet assez représentatif de son emballement. Dans le cas d'un court-circuit apparaissant à un niveau intermédiaire d'une ligne haute tension, ce seuil sera dépassé pour les limiteurs de courant présents aux deux extrémités de la ligne, avec seulement un décalage temporel entre ces limiteurs de courant, en fonction des distances respectives les séparant du court-circuit. Le circuit de commande 28 peut alternativement calculer le rapport de la tension mesurée aux bornes de chacun des limiteurs 251 à 253 sur le courant traversant ce limiteur respectif, pour déterminer si une résistance d'un limiteur a atteint un seuil d'emballement. Le circuit de commande 28 peut alternativement calculer pour chaque limiteur 251 à 253 sa valeur $I^2t$, avec I le courant traversant le limiteur concerné et « t » le temps, pour détecter d'éventuels points chauds et des défauts fortement résistifs, lorsque le courant de défaut est proche du courant critique du limiteur.

L'énergie stockée dans le condensateur 27 permet ainsi de déclencher plus facilement le limiteur de courant le plus proche de la borne sur laquelle le court-circuit est présent, du fait de la baisse de tension constatée sur la borne présentant le court-circuit. L'ouverture de l'interrupteur connecté en série avec ce limiteur peut ensuite être réalisée en un temps suffisamment bref avant que les zones autres limiteurs de courant n'induisent eux-mêmes l'ouverture de leurs interrupteurs commandés respectifs.

Un tel équipement d'interconnexion 2 s'avère avantageux puisqu'il permet de couper le courant pour isoler une borne présentant un court-circuit sans pour autant nécessiter une communication entre les différents équipements d'interconnexion du réseau. En outre, un tel équipement d'interconnexion 2 permet de rendre le réseau 1 nettement plus robuste du point de vue de la sélectivité dans les configurations critiques suivantes :

- une ligne haute tension (saine) reliée à l'équipement d'interconnexion qui subit le court-circuit est mise hors service (cela est vrai quand il y a au moins 3 bornes de connexions à des lignes haute tension depuis l'équipement d'interconnexion) ;
- l'équipement d'interconnexion qui subit le court-circuit est connecté à une ligne haute tension aérienne saine (cela est vrai quand il y a au moins 3 bornes de connexions à des lignes haute tension depuis l'équipement d'interconnexion)
- de fortes disparités de longueur des lignes hautes tension reliées à un équipement d'interconnexion ;
- une inversion du courant dans l'équipement d'interconnexion lors de l'apparition du court-circuit ;
- de fortes disparités des courants critiques pour les limiteurs de courant dans un même équipement d'interconnexion du réseau 1.
- l'équipement d'interconnexion qui subit le court-circuit est relié à une station de conversion (vrai pour un convertisseur MMC par exemple)

Les limiteurs de courant 251, 252 et 253 peuvent être de type résistif à supraconducteur. De tels limiteurs présentent une résistance nulle en fonctionnement normal et augmentant très fortement lorsqu'ils sont déclenchés. Les diagrammes des figures 3 et 4 sont représentatifs d'un exemple de fonctionnement de tels limiteurs. Un limiteur de courant à résistance supraconductrice comprend typiquement un ruban de matériau supraconducteur traversé par le courant nominal entre ses bornes (par exemple pour un limiteur de type YBCO). Le ruban de matériau supraconducteur baigne dans un bain d'azote liquide afin de le maintenir en dessous de sa température critique avant son déclenchement.

La figure 3 est un diagramme illustrant le mode de fonctionnement d'un limiteur de courant à résistance supraconductrice en fonction de la densité de courant qui le traverse et de sa température. Dans une première zone désignée par nd, le limiteur de courant est non dissipatif, du fait d'une faible densité de courant et d'une faible température. Dans une deuxième zone désignée par etd, le limiteur de courant est dans un état dissipatif. Dans une troisième zone désignée par ra, le limiteur de courant est dans un état d'emballement thermique très fortement dissipatif et permanent, désigné par le terme de runaway en langue anglaise. C'est dans cet état que le limiteur de courant assure l'essentiel de sa fonction de limitation de courant.

La figure 4 est un diagramme illustrant le temps de déclenchement en fonction du courant traversant le limiteur de courant (ici illustré par le rapport courant sur courant critique).

Selon l'invention, le but est de déclencher le limiteur de courant le plus proche de la borne présentant le court-circuit de façon à ouvrir son interrupteur avant que les autres limiteurs de courant de l'équipement n'aient atteint leur état d'emballement, et ce afin de garantir la continuité de service du réseau 1 du fait de l'excellente sélectivité obtenue.

On peut déterminer des critères de dimensionnement du condensateur 27 favorisant le déclenchement du limiteur de courant approprié. On pourra partir de l'hypothèse que le condensateur 27 doit pouvoir fournir une énergie suffisante pour permettre le déclenchement d'un limiteur de courant (atteinte de la température d'emballement du limiteur de courant) avant un certain délai. En supposant que les échanges thermiques sont sensiblement négligeables durant un emballement, on considérera alors que le limiteur de courant en état adiabatique pendant son emballement. Le bilan énergétique du limiteur de courant peut alors être formulé comme suit :

$$\int_{t1}^{tmax} v_{sc(t)} \times i_{sc(t)} \times dt = Vol \times \int_{T0}^{Tmax} Cp_{(T)} \times dT$$

Avec Vsc(t) la tension aux bornes du limiteur, $i_{sc}$(t) le courant le traversant, t1 l'instant d'apparition d'un défaut, tmax l'instant maximum de fin de la limitation, Tmax la température maximale de sécurité, Vol le volume du limiteur, To la température nominale de fonctionnement du limiteur de courant et Cp sa capacité thermique volumique.

En prenant comme hypothèse un instant de déclenchement (tquench) beaucoup plus précoce que l'instant de fin de limitation (t1 - tquench << t1 - tmax) le bilan énergétique peut être approximé comme suit :

$$\int_{tquench}^{tmax} v_{sc(t)} \times i_{sc(t)} \times dt = Vol \times \int_{Tc}^{Tmax} Cp_{(T)} \times dT$$

On en déduit :

$$Vgrid \times Ic \times \Delta t_{open} \approx Vol \times Cp_{moy(Tc-Tmax)} \times (Tmax - Tc) \ [1]$$

Avec Vgrid la tension du réseau haute tension, Ic le courant de limitation ou courant critique, Tc la température de déclenchement ou température critique du limiteur, Δtopen le temps maximum de limitation (tmax - tquench) et Cpmoy la capacité thermique moyenne entre Tc et Tmax.

L'énergie de déclenchement d'un limiteur de courant correspond à l'énergie nécessaire à faire monter sa température jusqu'à la température Tc comme suit :

$$E_{quench} = \int_{t1}^{t_{quench}} v_{sc(t)} \times i_{sc(t)} \times dt = Vol \int_{T0}^{Tc} Cp_{(T)} dT$$

On en déduit

$$E_{quench} \approx Vol \times Cp_{moy(T0-Tc)} \times (Tc - T0) \quad [2]$$

Les relations [1] et [2] permettent d'estimer l'énergie de déclenchement d'un limiteur de courant à partir des paramètres du réseau comme suit :

$$E_{quench} \approx \left(Vgrid \times Ic \times \Delta t_{open}\right)/k$$

$$k = \left[Vol \times Cp_{moy(Tc-Tmax)} \times (Tmax - Tc)\right]/\left[Vol \times Cp_{moy(T0-Tc)} \times (Tc - T0)\right]$$

$k \approx 20$, valeur typique pour un ruban YBCO

On en déduit :

$$E_{quench} \approx 0.05 \times Vgrid \times Ic \times \Delta t_{open}$$

Finalement, l'énergie stockée par le condensateur 27 doit permettre de déclencher le limiteur de courant avec le courant critique (Ic) le plus élevé (Icmax) parmi les différents limiteurs de courant qui composent le dispositif d'interconnexion, celui-là donnera la valeur de capacité minimale (Cmin) dans le cas où il n'y a pas d'autres sources de courant

$$E_{Cond} = 0.5 \times C \times Vgrid^2 \approx 0.05 \times Vgrid \times Ic \times \Delta t_{open}$$

On en déduit

$$Cmin \approx \left(0.1 \times Ic_{max} \times \Delta t_{open}\right)/Vgrid$$

Par exemple, pour un réseau avec une tension Vgrid de 320 kV, une courant critique Ic de 2.25 kA et un temps maximum de limitation de 25 ms, l'équation permet d'estimer une capacité de 17.58 μF.

Les limiteurs de courant 251 à 253 sont de préférence de type supraconducteur haute température de seconde génération (désigné par 2G HTS). De tels limiteurs de courant présentent une grande homogénéité de courant critique sur toute la longueur du matériau les constituant, avec par exemple des dispersions inférieures à 10%. Une telle homogénéité s'avère préférable pour des défauts fortement résistifs.

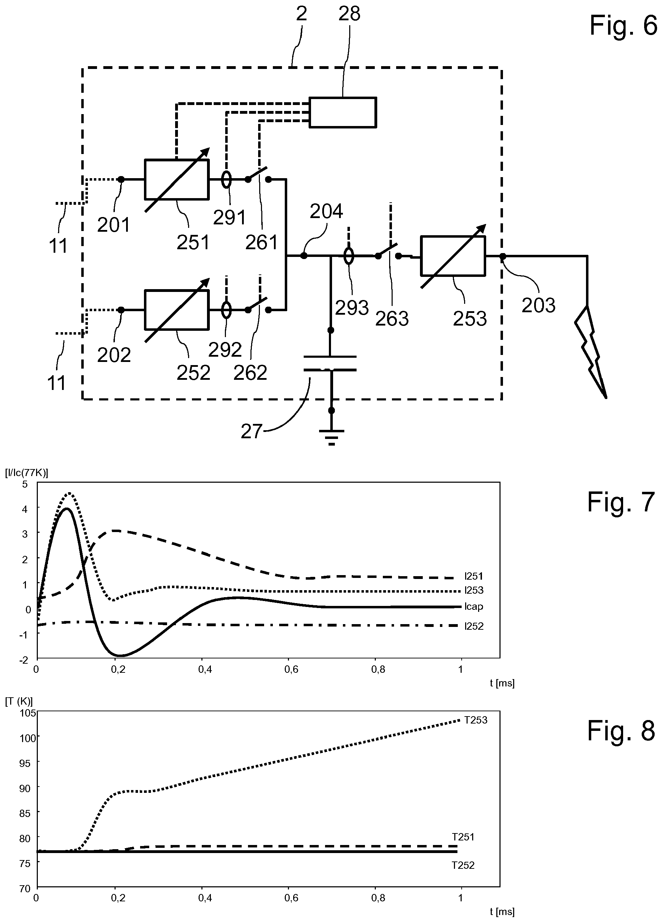

La figure 6 représente l'équipement d'interconnexion 2 de la figure 2 dans un exemple de configuration de court-circuit. Dans cet exemple, le court-circuit est présent au niveau de la connexion avec la borne 203. La sélectivité doit permettre l'ouverture de l'interrupteur commandé 263 avant l'activation des limiteurs de courant 251 et 252, de façon à maintenir l'interconnexion des lignes haute tension 11 par l'intermédiaire du nœud 204. Le fonctionnement de l'équipement d'interconnexion 2 ressortira plus clairement à la lecture des diagrammes des figures 7 et 8.

La figure 7 illustre différents rapports courant/courant critique en fonction du temps. Des impédances différentes sont présentes sur les lignes haute tension connectées aux limiteurs de courant 251 et 252. La simulation a ici été réalisée avec un même courant critique pour chacun des limiteurs de courant 251 à 253. Le courant normalisé Icap illustré en trait plein illustre le courant traversant le condensateur 27. Le courant normalisé I251 en trait discontinu représente le courant à travers le limiteur de courant 251. Le courant normalisé I252 en alternance trait/points représente le courant à travers le limiteur de courant 252. Le courant normalisé I253 en pointillés représente le courant à travers le limiteur de courant 253. La figure 8 illustre les températures des différents limiteurs de courant à supraconducteur, en fonction du temps.

Lors de l'apparition du court-circuit à l'instant t=0, le condensateur 27 débite à travers le limiteur de courant 253 vers le court-circuit. Le courant traversant le limiteur de courant 253 atteint plusieurs fois le courant critique du limiteur 253, de façon à créer son emballement et le déclencher. L'impédance du limiteur de courant 253 croit, de sorte que le courant traversant le limiteur de courant 253 décroit alors, jusqu'à une valeur proche autour du courant critique. Du fait de l'augmentation de la tension aux bornes du limiteur de courant 253 et du niveau de courant le traversant, le circuit de commande 28 détermine que l'interrupteur 263 doit être ouvert. L'interrupteur 263 peut alors être ouvert (non illustré sur les diagrammes) avec un courant le traversant inférieur à son pouvoir de coupure. Entretemps, les courants à travers les limiteurs 251 et 252 croissent également. Le déclenchement du limiteur de courant 253 permet de maintenir les limiteurs de courant 251 et 252 hors de leur zone d'emballement. Il n'est ainsi pas nécessaire de disposer d'interrupteurs commandés 261 à 263 particulièrement rapides, ce qui rend le coût de fabrication de l'équipement d'interconnexion 2 raisonnable.

Chaque branche de l'équipement d'interconnexion 2 pourra par exemple être dimensionnée pour des tensions continues au moins égales à 10 kV, voire au moins égales à 50 kV, typiquement au moins égales à 100 kV, et potentiellement au moins égales à 300kV, voire 500kV. Un tel dispositif de coupure de courant pourra également être dimensionné pour un courant continu de service au moins égal à 1 kA, voire au moins égal à 2 kA.

En disposant des équipements d'interconnexion 2 aux extrémités des différentes lignes haute tension, une sélectivité est obtenue pour permettre de déclencher d'abord l'équipement d'interconnexion le plus proche du court-circuit sur cette ligne, du fait des différences d'impédance de part et d'autre du court-circuit.

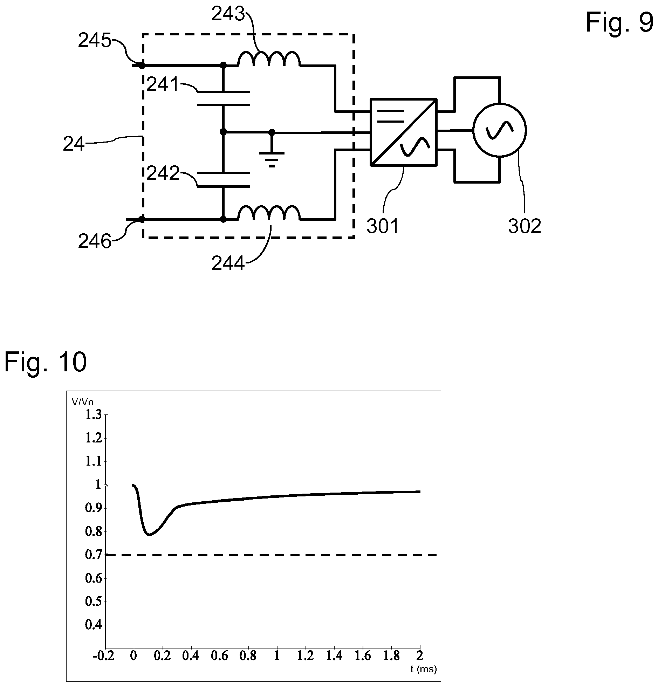

La figure 9 illustre de façon schématique un dispositif de protection 24 pouvant être connecté à l'entrée d'un convertisseur modulaire multi-niveaux 301. Le dispositif de protection 24 est avantageusement utilisé en combinaison avec un équipement d'interconnexion 2, afin de protéger le convertisseur 301 et son équipement ou réseau alternatif 302. Le dispositif de protection 24 comporte une borne d'entrée 245 destinée à la connexion d'une ligne intermédiaire haute tension d'une première polarité. Le dispositif de protection 24 comporte également une borne d'entrée 246 destinée à la connexion d'une ligne intermédiaire haute tension d'une deuxième polarité. Ces lignes haute tension intermédiaires sont elles même connectées à l'équipement d'interconnexion 23, comme illustré à la figure 1. Une inductance 243 est connectée entre une première entrée du convertisseur 301 et la borne d'entrée 245. Une inductance 244 est connectée entre une deuxième entrée du convertisseur 301 et la borne d'entrée 246. Un condensateur 241 est connecté entre la borne d'entrée 245 et la terre. Un condensateur 242 est connecté entre la borne d'entrée 246 et la terre. Les condensateurs 241 et 242 permettent par exemple de déclencher des limiteurs de courant (non illustrés) et des interrupteurs commandés de dispositifs de sécurité connectés aux bornes d'entrée 245 et 246. Les inductances 243 et 244 sont notamment destinées à garantir le contrôle du convertisseur 301 au cas où un court-circuit interviendrait dans le réseau, particulièrement pour le type de convertisseur détaillé précédemment. Le but est notamment de garantir que les tensions aux bornes du convertisseur côté continu 301 restent supérieures aux tensions côté alternatif. Le but est notamment de conserver une tension sur chaque borne de courant continu au moins égale à 0,7 fois la tension nominale sur les lignes hautes tension connectées au dispositif de protection 24. Une réactance peut être placée en sortie du convertisseur, pour faciliter le contrôle du convertisseur pendant le défaut, en particulier pour un convertisseur multiniveaux de type demi-pont.

Avec un niveau de tension nominale de 320kV sur ces lignes haute tension, avec une longueur de 350km pour ces lignes haute tension, une simulation a permis de déterminer que des condensateurs 241 et 242 de $5\mu F$ et des inductances 243 et 244 de 10mH s'avéraient satisfaisants. Une simulation avec de tels composants est notamment illustrée à la figure 10, pour un court-circuit intervenant au niveau du convertisseur 301. Le diagramme de la figure 10 illustre le rapport de la tension sur une borne d'entrée sur la tension nominale de sa ligne haute tension, en fonction du temps.

Le dispositif d'injection de courant dans le nœud de l'équipement d'interconnexion 22 est un condensateur dans l'exemple détaillé précédemment. On peut également envisager que le dispositif d'injection soit formé d'un convertisseur continu/continu, configuré pour injecter un courant dans le nœud 204 lors d'une baisse de tension sur ce nœud, le convertisseur étant configuré pour injecteur un courant avec une énergie Equench vérifiant la relation

$$E_{quench} \geq 1/\mathrm{k} \times Vi \times Ic \times \Delta t_{open}$$

Avec

$$k = \left[Vol \times Cp_{moy(Tc-Tmax)} \times (Tmax - Tc)\right] / \left[Vol \times Cp_{moy(T0-Tc)} \times (Tc - T0)\right]$$

Avec Δtopen la durée maximale tolérée pour le défaut. Δtopen pourra par exemple être de l'ordre de 10ms, ou de l'ordre de 25ms.

**Revendications**

1. Equipement d'interconnexion (2) pour réseau haute tension courant continu, comprenant :

   - des première et deuxième bornes configurées pour la connexion à des première et deuxième lignes d'un réseau haute tension courant continu (201, 202), une troisième borne (203) configurée pour la connexion à une station locale ou une ligne du réseau haute tension ;
   - un nœud (204) connecté aux première à troisième bornes (201, 203) ; **Caractérisé en ce qu'**il comprend :

      - un premier limiteur de courant à supraconducteur (251) et un premier interrupteur commandé (261) connectés en série entre la première borne et ledit nœud ;
      - un deuxième limiteur de courant à supraconducteur et un deuxième interrupteur commandé connectés en série entre la deuxième borne et ledit nœud ;
      - un troisième limiteur de courant à supraconducteur et un troisième interrupteur commandé connectés en série entre la troisième borne et ledit nœud ;
      - un dispositif configuré pour injecter un courant électrique dans ledit nœud lors d'une baisse de tension sur ledit nœud.

2. Equipement d'interconnexion (2) pour réseau haute tension courant continu selon la revendication 1, dans lequel ledit dispositif d'injection de courant électrique est configuré pour injecter un courant avec une énergie Equench vérifiant la relation suivante :

$$E_{quench} \geq 1/\mathrm{k} \times Vi \times Ic \times \Delta t_{open}$$

Avec Vi la tension nominale sur les première et deuxième bornes, Ic le courant critique du limiteur ayant le courant critique le plus élevé parmi les premier à troisième limiteurs de courant à supraconducteur, Δtopen la durée maximale tolérée pour un défaut,

$$k = \left[Vol \times Cp_{moy(Tc-Tmax)} \times (Tmax - Tc)\right]/\left[Vol \times Cp_{moy(T0-Tc)} \times (Tc - T0)\right],$$

avec Cpmoy la capacité thermique moyenne entre deux températures pour ce limiteur de courant, Tmax sa température maximale de sécurité, Tc sa température de déclenchement, T0 sa température nominale de fonctionnement, Vol son volume de matériau supraconducteur.

3. Equipement d'interconnexion (2) pour réseau haute tension courant continu selon la revendication 1 ou 2, dans lequel ledit dispositif d'injection de courant électrique est un condensateur (27) connecté entre ledit nœud (204) et la terre.

4. Equipement d'interconnexion (2) selon la revendication 3, dans lequel la capacité C du condensateur (27) vérifie la relation suivante :

$$C \geq \left(0.1 \times Ic \times \Delta t_{open}\right)/Vi$$

5. Equipement d'interconnexion (2) selon l'une quelconque des revendications précédentes, comprenant en outre un circuit de commande (28) desdits premier à troisième interrupteurs commandés (261,262,263), configuré pour mesurer les tensions respectives aux bornes desdits premier à troisième limiteurs de courant (251,252,253) et pour mesurer les courants traversant les premier à troisième limiteurs de courant, ledit circuit de commande (28) étant en outre configuré pour générer une commande d'ouverture d'un desdits interrupteurs commandés lorsque la tension aux bornes du limiteur de courant avec lequel il est connecté en série dépasse un premier seuil et que le courant traversant ce limiteur de courant dépasse également un deuxième seuil.

8

6.  Equipement d'interconnexion selon l'une quelconque des revendications 1 à 4, comprenant en outre un circuit de commande (28) desdits premier à troisième interrupteurs commandés (261,262,263), configuré pour générer une commande d'ouverture d'un desdits interrupteurs commandés lorsque le carré de la tension aux bornes du limiteur de courant avec lequel il est connecté en série dépasse un troisième seuil, ou lorsque le rapport tension aux bornes du limiteur de courant sur courant traversant ce limiteur de courant dépasse un quatrième seuil.

7.  Equipement d'interconnexion (2) selon la revendication 5 ou 6, dans lequel ledit circuit de commande (28) est configuré pour générer ladite commande d'ouverture de l'interrupteur commandé au plus 1 ms soit après le franchissement des premier et deuxième seuils, soit après le franchissement du troisième seuil.

8.  Equipement d'interconnexion (2) selon l'une quelconque des revendications précédentes, dimensionné pour l'application d'une tension au moins égale à 10 kV et d'un courant au moins égal à 1 kA sur l'une quelconque desdites première à troisième bornes.

9.  Equipement d'interconnexion (2) selon l'une quelconque des revendications précédentes, dans lequel lesdits premier à troisième interrupteurs commandés (261, 262, 263) sont des interrupteurs électromécaniques présentant un temps de coupure compris entre 5ms et 50ms.

10. Réseau électrique haute tension courant continu (1), comprenant :

    - des lignes hautes tension (112, 113, 123, 133) ;
    - au moins trois équipements d'interconnexion (21,22, 23) selon l'une quelconque des revendications précédentes, les première et deuxième bornes de chacun desdits équipements d'interconnexion étant interconnectées par l'intermédiaire desdites lignes hautes tensions.


**Patentansprüche**

1.  Verbindungsausrüstung (2) für ein Hochspannungs-Gleichstromnetz, aufweisend:

    - erste und zweite Anschlüsse, die für die Verbindung mit einer ersten und einer zweiten Leitung eines Hochspannungs-Gleichstromnetzes (201, 202), konfiguriert sind, einen dritten Anschluss (203), der für die Verbindung mit einer lokalen Station oder einer Leitung des Hochspannungsnetzes konfiguriert ist;
    - einen Knoten (204), der mit den ersten zu den dritten Anschlüssen (201, 203) verbunden ist;

    **dadurch gekennzeichnet, dass** sie aufweist:

    - einen ersten Supraleiter-Strombegrenzer (251) und einen ersten gesteuerten Schalter (261), die zwischen dem ersten Anschluss und dem Knoten in Reihe geschaltet sind;
    - und einen zweiten Supraleiter-Strombegrenzer und einen zweiten gesteuerten Schalter, die zwischen dem zweiten Anschluss und dem Knoten in Reihe geschaltet sind;
    - einen dritten Supraleiter-Strombegrenzer und einen dritten gesteuerten Schalter, die zwischen dem dritten Anschluss und dem Knoten in Reihe geschaltet sind;
    - eine Vorrichtung, die konfiguriert ist, um einen elektrischen Strom während eines Spannungsabfalls auf dem Knoten in den Knoten einzukoppeln.

2.  Verbindungsausrüstung (2) für ein Hochspannungs-Gleichstromnetz nach Anspruch 1, in der die Einkopplungsvorrichtung für elektrischen Strom konfiguriert ist, um einen Strom mit einer Energie Equench einzukoppeln, der folgende Gleichung erfüllt:

$$E_{quench} \geq 1/\text{k x } Vi \text{ x } Ic \text{ x } \Delta t_{open}$$

wobei Vi die Nennspannung an dem ersten und dem zweiten Anschluss, Ic der kritische Strom des Begrenzers mit dem höchsten kritischen Strom von dem ersten bis dritten Strombegrenzer mit Supraleiter, $\Delta$topen die maximale tolerierte Dauer für einen Fehler ist,

$$k = \left[Vol \times Cp_{moy(Tc-Tmax)} \times (Tmax - Tc)\right] / \left[Vol \times Cp_{moy(T0-Tc)} \times (Tc - T0)\right],$$

wobei Cpmoy die mittlere Wärmekapazität von zwei Temperaturen für diesen Strombegrenzer, Tmax seine maximale Sicherheitstemperatur, Tc seine Auslösetemperatur, T0 seine Nennbetriebstemperatur, Vol sein Supraleitermaterial-Volumen ist.

3. Verbindungsausrüstung (2) für ein Hochspannungs-Gleichstromnetz nach Anspruch 1 oder 2, in der die Einkopplungsvorrichtung für elektrischen Strom ein Kondensator (27) ist, der zwischen dem Knoten (204) und der Masse angeschlossen ist.

4. Verbindungsausrüstung (2) nach Anspruch 3, in der die Kapazität C des Kondensators (27) die folgende Gleichung erfüllt:

$$C \geq (0.1 \text{ x } \; I_c \; \text{ x } \; \Delta t_{open}) / Vi$$

5. Verbindungsausrüstung (2) nach einem der vorhergehenden Ansprüche, die des Weiteren einen Steuerschaltkreis (28) des ersten bis dritten gesteuerten Schalters (261, 262, 263) aufweist, der konfiguriert ist, um die jeweiligen Spannungen an den Anschlüssen des ersten bis dritten Strombegrenzers (251, 252, 253) zu messen, und um die Ströme zu messen, die den ersten bis dritten Strombegrenzer durchfließen, wobei der Steuerschaltkreis (28) des Weiteren konfiguriert ist, um einen Befehl zum Öffnen von einem der gesteuerten Schalter zu erzeugen, wenn die Spannung an den Anschlüssen des Strombegrenzers, mit dem er in Reihe geschaltet ist, einen ersten Schwellenwert überschreitet und der Strom, der diesen Strombegrenzer durchfließt, ebenfalls einen zweiten Schwellenwert überschreitet.

6. Verbindungsausrüstung nach einem der Ansprüche 1 bis 4, aufweisend des Weiteren einen Steuerschaltkreis (28) des ersten bis dritten gesteuerten Schalters (261, 262, 263), der konfiguriert ist, um einen Befehl zum Öffnen von einem der gesteuerten Schalter zu erzeugen, wenn das Quadrat der Spannung an den Anschlüssen des Strombegrenzers, mit dem er in Reihe geschaltet ist, einen dritten Schwellenwert überschreitet, oder wenn das Verhältnis der Spannung an den Anschlüssen des Strombegrenzers zum Strom, der diesen Strombegrenzer durchfliesst, einen vierten Schwellenwert überschreitet.

7. Verbindungsausrüstung (2) nach Anspruch 5 oder 6, in der der Steuerschaltkreis (28) konfiguriert ist, um den Befehl zum Öffnen des gesteuerten Schalters maximal 1 ms nach dem Überschreiten des ersten und des zweiten Schwellenwerts, oder nach dem Überschreiten des dritten Schwellenwerts zu erzeugen.

8. Verbindungsausrüstung (2) nach einem der vorhergehenden Ansprüche, die für das Anlegen einer Spannung von mindestens gleich 10 kV und einem Strom von mindestens gleich 1kA auf einem von dem ersten bis dritten Anschluss ausgelegt ist.

9. Verbindungsausrüstung (2) nach einem der vorhergehenden Ansprüche, in der der erste bis dritte gesteuerte Schalter (261, 262, 263) elektromechanische Schalter sind, die eine Abschaltzeit zwischen 5 ms und 50 ms aufweisen.

10. Elektrisches Hochspannungs-Gleichstromnetz (1), aufweisend:

   - Hochspannungsleitungen (112, 113, 123, 133);
   - mindestens drei Verbindungsausrüstungen (21, 22, 23) nach einem der vorhergehenden Ansprüche, wobei die erste und zweite Anschlüsse von jeder der Verbindungsausrüstungen mittels der Hochspannungsleitungen miteinander verbunden sind.

**Claims**

1. Interconnection equipment (2) for a high-voltage direct current network, comprising:

   - first and second terminals configured for connection to first and second lines of a high-voltage direct current network (201, 202), a third terminal (203) configured for connection to a local station or to a line of the high-voltage network;
- a node (204) connected to the first to third terminals (201, 203);

**characterised in that** it comprises:

- a first superconducting current limiter (251) and a first controlled switch (261) connected in series between the first terminal and said node;
- a second superconducting current limiter and a second controlled switch connected in series between the second terminal and said node;
- a third superconducting current limiter and a third controlled switch connected in series between the third terminal and said node;
- a device configured to inject an electric current into said node during a voltage drop on said node.

2. Interconnection equipment (2) for a high-voltage direct current network according to claim 1, wherein said electric current injection device is configured to inject a current with energy Equench verifying the following relation:

$$E_{quench} \geq 1/\text{k} \times Vi \times Ic \times \Delta t_{\text{open}},$$

with Vi being the nominal voltage on the first and second terminals, Ic being the critical current of the limiter having the highest critical current from among the first to third superconducting current limiters, Δtopen being the maximum tolerated duration for a fault,

$$k = \left[ Vol \times Cp_{moy(Tc-Tmax)} \times (Tmax - Tc) \right] / \left[ Vol \times Cp_{moy(T0-Tc)} \times (Tc - T0) \right],$$

with Cpmoy being the average thermal capacity between two temperatures for this current limiter, Tmax being its maximum safety temperature, Tc being its trigger temperature, T0 being its nominal operating temperature, Vol being its volume of superconducting material.

3. Interconnection equipment (2) for a high-voltage direct current network according to claim 1 or 2, wherein said electric current injection device is a capacitor (27) connected between said node (204) and the ground.

4. Interconnection equipment (2) according to claim 3, wherein the capacitance C of the capacitor (27) verifies the following relation:

$$C \geq (0.1 \times I c \times \Delta t_{open}) / Vi.$$

5. Interconnection equipment (2) according to any one of the preceding claims, further comprising a circuit (28) for controlling said first to third controlled switches (261, 262, 263), configured to measure the respective voltages at the terminals of said first to third current limiters (251, 252, 253) and to measure the currents passing through the first to third current limiters, said control circuit (28) also being configured to generate a command to open one of said controlled switches when the voltage at the terminals of the current limiter to which it is connected in series exceeds a first threshold and when the current passing through this current limiter also exceeds a second threshold.

6. Interconnection equipment according to any one of claims 1 to 4, further comprising a circuit (28) for controlling said first to third controlled switches (261, 262, 263), configured to generate a command to open one of said controlled switches when the square of the voltage at the terminals of the current limiter to which it is connected in series exceeds a third threshold or when the ratio of the voltage at the terminals of the current limiter to the current passing through this current limiter exceeds a fourth threshold.

7. Interconnection equipment (2) according to claim 5 or 6, wherein said control circuit (28) is configured to generate said command to open the controlled switch at the most 1 ms either after the first and second thresholds are exceeded or after the third threshold is exceeded.

8. Interconnection equipment (2) according to any one of the preceding claims, designed to apply a voltage that is at least equal to 10 kV and a current that is at least equal to 1 kA on any one of said first to third terminals.

9. Interconnection equipment (2) according to any one of the preceding claims, wherein said first to third controlled switches (261, 262, 263) are electromechanical switches having a cut-off time that is between 5 ms and 50 ms.

10. High-voltage direct current electrical network (1), comprising:

   - high-voltage lines (112, 113, 123, 133);
   - at least three items of interconnection equipment (21, 22, 23) according to any one of the preceding claims, the first and second terminals of each of said items of interconnection equipment being interconnected by means of said high-voltage lines.

Fig. 1

Fig. 2

Jc(A/s²)

Jc(T0)

etd          ra

nd

T0                    Tc

                      T

**Fig. 3**

t(ms)

1000

10

0,1                    ra

0,001              etd

1          2          3

                I/Ic(77K)

**Fig. 4**

**Fig. 5**

28

285

281          282

283    284

Fig. 6

Fig. 7

Fig. 8

Fig. 9

Fig. 10

# EP 3 363 093 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2908398 A **[0007]**
- WO 2012123015 A **[0008]**

**Littérature non-brevet citée dans la description**

- **JUSTINE DESCLOUX.** Protection system for meshed HVDC network using superconducting fault current limiters. *le cadre de la conférence de l'IEEE à Grenoble en 2013,* 16 Juin 2013, 1-5 **[0006]**